# FASCICULE DE BREVET EUROPEEN

(11) **EP 0 731 060 B1**
(45) Date de publication et mention de la délivrance du brevet: **09.06.1999**
(21) Numéro de dépôt: 96400482.4
(22) Date de dépôt: 07.03.1996
(51) Int. Cl.: C01G 49/00, C01G 25/00, C04B 35/468, C04B 35/491, H01L 41/187

(54) **Pérovskites ferroélectriques**
Ferroelektrische Perovskite
Ferroelectric perovskites

(30) Priorité: 09.03.1995 FR 9502744
(43) Date de publication de la demande: 11.09.1996
(73) Titulaire: ETAT FRANCAIS Représenté par le Délégué Général pour l'Armement, 75007 Paris 7ème (FR)
(72) Inventeur: Eyraud, Lucien, 69005 Lyon (FR); Boisrayon, Michel, 83330 Beausset (FR); Eyraud, Paul-Aubin, "Les jardins d'Arcadie n 2", 69130 Ecully (FR); Eyraud, Franck, 92120 Montrouge (FR); Audigier, David, 69140 Rillieux-La-Pape (FR)

(56) Documents cités:
- EP-A- 0 061 389
- FR-A- 2 248 587
- US-A- 3 753 911
- DATABASE WPI Derwent Publications Ltd., London, GB; AN 77-26057y XP002005244 & JP-A-52 027 599 (MITSUBISHI CHEM IND)
- DATABASE WPI Derwent Publications Ltd., London, GB; AN 78-15136a XP002005245 & JP-A-53 003 698 (MITSUBISHI CHEM IND)

## Description

La présente invention concerne la préparation des pérovskites ferroélectriques présentant des propriétés piézoélectriques jusqu'à une température d'environ 300°C, du type titanozirconate de plomb (noté PZT dans la suite du texte).

Les pérovskites du type PZT sont utilisées comme matière première de céramiques piézo-électriques de transducteurs électroacoustiques.

Le brevet FR 2 248 587 décrit des matériaux diéléctriques de ce type, fluoré, notamment des pérovskites, utilisés pour la fabrication des condensateurs. Ces matériaux ne sont pas ferroélectriques à température ambiante et le brevet précité enseigne leurs propriétés diélectriques améliorées et stabilisées en fonction de la température.

Mais la présente invention vise plus particulièrement les céramiques de puissance, c'est à dire des céramiques utilisées dans des transducteurs émettant des ondes acoustiques. Toutefois, l'invention présente aussi un intérêt vis à vis des céramiques présentes dans les transducteurs utilisés en réception.

Les céramiques de type PZT correspondant à la formule suivante, du type ABO₃ :

[Pb X] [Zr Ti Y] O₃

où X est un ion de substitution du site A (c'est-à-dire PbX) et Y un ion de substitution du site B (c'est-à-dire ZrTiY), la taille et la valence de ces ions de substitution étant compatibles avec l'équilibre du réseau pérovskite. Les substitutions cationiques hétérovalentes le plus souvent utilisées pour obtenir un réseau lacunaire en oxygène sont des substitutions par le sodium ou le potassium en site A et/ou par le fer, le manganèse ou le nickel en site B.

La présence de ces lacunes entraîne une diminution des pertes diélectriques sous hauts niveaux de champs électriques.

Les poudres de ces produits, obtenues soit par réaction en phase solide soit par coprécipitation, sont agglomérées avec un liant convenable, séchées, moulées sous pression, frittées à haute température (entre 1000 et 1300°C). On obtient ainsi des céramiques compactes qui peuvent être usinées, pourvues d'électrodes, puis polarisées sous tension continue dans un bain isolant.

Les céramiques ainsi obtenues utilisées en émission ont un bon rapport de l'énergie dissipée sous la forme calorifique sur l'énergie moyenne fournie. En effet, la tangente de l'angle de pertes, à 1 kHz et sous faible champ électrique (5 V/mm) de l'ordre de 0,3 à 0,5 %. La valeur de cette tangente est comprise entre 0,8 et 1,5 % sous des champs de l'ordre de 400 V/mm, cette valeur de champ électrique étant usuelle pour alimenter les transducteurs d'émission équipant les antennes de sonar. Ces pertes entraînent un échauffement qui limite le domaine d'utilisation des transducteurs de puissance. Dans d'autres domaines, comme ceux de l'usinage, de la soudure, des moteurs piézo-électriques et du nettoyage industriel, les céramiques étant utilisées à la limite extrême de leurs possibilités, des défaillances mécaniques apparaissent fréquemment.

Les céramiques utilisées en réception possèdent un rapport signal/bruit plus ou moins élevé, ce qui affaiblit la netteté du signal émis.

De plus, le taux de déchet des céramiques (c'est à dire le taux de céramiques ne présentant pas de caractéristiques piézo-électriques prédéterminées) fabriquées par les procédés industriels classiques est important, ces produits étant très sensibles aux conditions de fabrication.

Ces céramiques lacunaires en oxygène présentent les défauts suivants. La conductivité électrique non négligeable par rapport au matériau non lacunaire peut entraîner des claquages électriques à la polarisation. On constate un hystérésis non négligeable des caractéristiques électromécaniques des céramiques soumises à de forts niveaux de sollicitations, ainsi que le vieillissement de ces caractéristiques. Enfin, la stabilité de la polarisation rémanente sous haut niveau de sollicitation est insuffisante.

L'invention a donc pour but de pallier les inconvénients relevés ci-dessus et, particulièrement, de réduire les pertes globales (pertes diélectriques, électriques et mécaniques) apparaissant dans les céramiques à base de pérovskites ferroélectriques utilisées en émission, et d'augmenter la stabilité. Elle a aussi pour but d'augmenter le rapport signal/bruit des céramiques appliquées à la réception, et dans les deux cas, de réduire le taux de déchet lors de leur fabrication.

Ainsi, la présente invention a pour objet un procédé de fabrication de pérovskite ferroélectrique pour la préparation de céramique PZT de formule[Pbx].[ZrTiY]o₃, et comportant des cations de substitution capables d'induire la formation de lacunes en oxygène, caractérisé en ce qu'il comprend les étapes suivantes :
- co-précipitation des différents cations composant la pérovskite de manière à créer des lacunes d'oxygène,
- mélange du précipité formé et d'un fluorure métallique ou non métallique,
- traitement thermique permettant l'insertion d'ions florures dans les lacunes d'oxygène, pour obtenir des propriétés piézoélectriques jusqu'à 300°C.

Dans un mode de mise en oeuvre en voie liquide par coprécipitation selon l'invention, un procédé comporte les étapes successives suivantes :
- une coprécipitation des principaux cations composant la pérovskite,
- un mélange du précipité formé d'un fluorure métallique ou non métallique,
- un traitement thermique à environ 600°C permettant l'insertion d'ions fluorures dans des lacunes d'oxygène et/ou des sites anioniques du réseau pérovskite.

En variante par voie solide, ces procédés comportent les étapes successives suivantes :
- un mélange d'un composé fluoré avec différents composés, notamment des oxydes, des hydroxydes et des oxalates des métaux et/ou des métalloïdes composant la pérovskite,
- un traitement thermique à basse température d'environ 600°C permettant la formation et fluoration de la pérovskite.

Un mécanisme de fluoration consiste à introduire les ions fluorures dans des lacunes d'oxygène, et/ou des sites anioniques du réseau pérovskite. On sait que ces lacunes sont créées soit par l'introduction dans la maille d'un cation de valence inférieure à celle du cation auquel il se substitue (par exemple l'introduction d'un cation Fe³⁺ à la place d'un cation Ti ⁴⁺ dans la pérovskite PbZrTiO₃), soit par la présence d'un cation de valence inférieure à sa valence normale (par exemple la présence d'un cation Ti ³⁺ à la place d'un cation Ti ⁴⁺ dans la même pérovskite). Aussi, lors de la coprécipitation, on forme un composé non stoechiométrique comprenant un déficit en oxygène et en cation.

Le procédé selon l'invention permet en particulier d'obtenir un composé doublement substitué en cations et en anions. Pour qu'il soit possible d'obtenir une pérovskite fluorée ferroélectrique présentant les propriétés requises ci-dessus, il est nécessaire que la maille présente des lacunes ou des déficits en oxygène, et pour ce faire, on sait qu'il faut substituer un cation par un cation ayant une valence inférieure. Il faut donc une double substitution : une substitution cationique et une anionique (cette substitution étant la substitution de l'oxygène par le fluor).

Une telle technique n'est pas envisagée dans le document JP-A-52 027 599 qui divulgue bien l'introduction d'ions fluorures dans le coprécipité de Pb, Zr et Ti, mais sans divulguer l'introduction préalable desdits cations de substitution.

Il est possible de fabriquer, à partir de ces pérovskites fluorées, des céramiques piézo-électriques de puissance du type PZT fluoré.

Aussi, les céramiques du type PZT fluoré, préparées par les procédés selon l'invention, ayant une fraction molaire de fluor au moins égale à 0,5% présentent la propriété surprenante d'avoir une tangente de l'angle de pertes inférieure à 0,6% sous 400 V/mm. Ceci permet d'augmenter notablement la puissance acoustique volumique des céramiques de puissance et donc de construire différents dispositifs utilisant ces céramiques, par exemples des corps remorqués pour sonar, plus compacts, plus maniables et moins coûteux. On peut également, en utilisant ces céramiques à la réception, augmenter sensiblement le rapport signal/bruit des hydrophones.

De plus, le taux de déchet de céramiques se trouve réduit lors de l'utilisation des procédés selon l'invention.

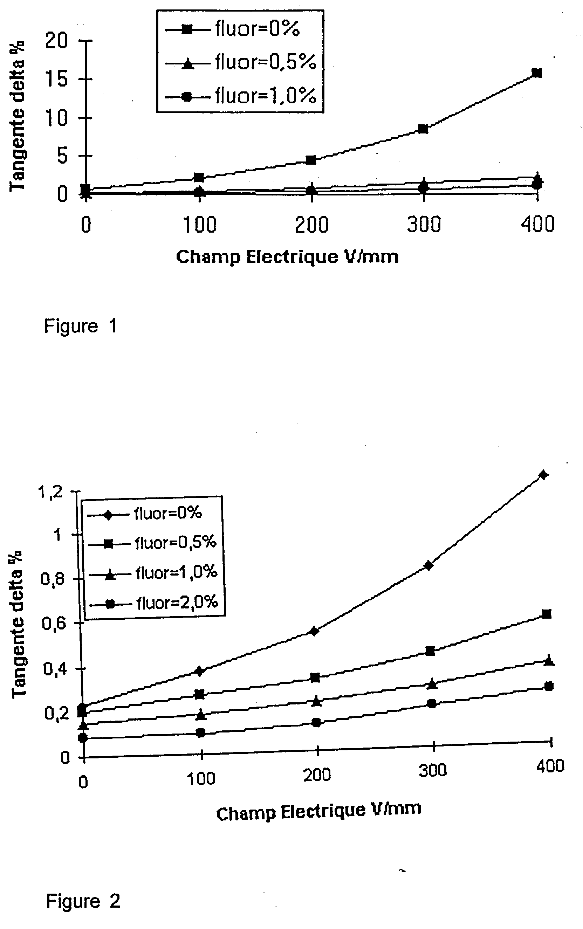

En indiquant la variation de la tangente de l'angle de perte d'une céramique en fonction du champ électrique auquel elle est soumise, la figure 1 illustre l'influence de la fluoration d'un réseau pérovskite, dont la seule substitution cationique est une substitution "non volontaire" (substitution de Ti⁴⁺ par Ti³⁺), sur les pertes diélectriques des céramiques, tandis que la figure 2 illustre l'influence de la fluoration d'un réseau pérovskite présentant une substitution des ions Ti⁴⁺ par des ions Fe³⁺.

Ces deux figures montrent que les pertes diélectriques des céramiques du type PZT fluoré sont nettement inférieures à celles des céramiques non fluorées, surtout sous des champs électriques importants. Les pourcentages indiqués sur ces figures sont des pourcentages molaires.

Pour le cas où la substitution cationique est "naturelle" (figure 1), les pertes sont notablement diminuées. Aussi, ces céramiques ne peuvent elles pas être utilisées en tant que céramiques de puissance. La fluoration augmente, par ailleurs, le rapport signal/bruit, d'où leur intérêt en réception, et leur stabilité en émission.

La fluoration d'un réseau pérovskite présentant une substitution cationique volontaire (figure 2 : substitution de Ti⁴⁺ par Fe³⁺) permet d'utiliser les céramiques en émission, même sous de forts champs électriques.

De plus le taux de déchet de céramiques fabriquées se trouve réduit lors de l'utilisation de ce nouveau procédé.

Deux exemplaires de fabrication de pérovskites PZT fluorés sont donnés ci-après, ces exemples n'étant pas limitatifs.

### Exemple 1 :

A 4000 cm³ d'une solution d'eau distillée on ajoute 320 g d'acide oxalique, 223,02 g de butylate de zirconium, 163,52 g de butylate de titane et 2,43 g de chlorure de fer. Ce mélange est agité jusqu'à la dissolution complète des composés. On y ajoute alors 335,90 g d'acétate de plomb et 30,65 g d'acétate de baryum dissous dans 1500 cm³ d'eau.

Cette solution est agitée pendant quatre heures, puis son pH est ajusté à l9 par l'addition d'hydroxyde d'ammonium. Le précipité formé, recueilli en décantant et filtrant la solution, est séché. Ce précipité contient donc des oxalates et des hydroxydes des différents métaux cités.

Ce précipité et 1,225 g de fluorure de plomb sont ensuite mélangés au mortier pendant une heure. Le mélange, après séchage, subit un traitement thermique de dix heures à 600°C, puis de quatre heures à 800°C. On obtient 319,57 g de poudre de PZT fluoré. Le rendement est de 99,3%.

### Exemple 2

A 4000 cm³ d'une solution d'eau distillée, on ajoute 320 g d'acide oxalique, 223,01 g de butylate de zirconium, 163,52 g de butylate de titane, 1,62 g de chlorure de fer et 0,73 g d'acétate de manganèse. Ce mélange est agité jusqu'à la dissolution complète des composés. On y ajoute alors 335,90 g d'acétate de plomb et 30,65 g d'acétate de baryum dissous dans 1500 cm³ d'eau. Cette solution est agitée pendant quatre heures, puis son pH est ajusté à 9 par l'addition d'hydroxyde d'ammonium.

Le précipité formé, recueilli en décantant et filtrant la solution, est séché. Ce précipité et 1,838 g de fluorure de plomb sont mélangés au mortier pendant une heure.

Le mélange, après séchage, subit, un traitement thermique de dix heures à 600°C puis de quatre heures à 800°C. On obtient 318 g de poudre de PZT fluoré. Le rendement est de 99%.

A ces poudres sont additionnés 10% en poids d'alcool polyvinylique. L'ensemble est séché puis désaggloméré. Le produit obtenu est moulé sous une pression de 1000 bars puis traité thermiquement pendant quatre heures à 450°C pour enlever le liant et fritté. Après usinage, on obtient des disques soit de 20 mm de diamètre et de 10 mm d'épaisseur, soit de 6,35 mm de diamètre et de 15 mm d'épaisseur. Les céramiques obtenues sont pourvues d'électrodes, c'est-à-dire métallisées, et polarisées dans un bain isolant à 150°C par l'action d'un champ électrique de l'ordre de 3 à 5 kV/mm.

## Revendications

1. Procédé de fabrication de pérovskite ferroélectrique pour la préparation de céramique PZT de formule [Pbx].[ZrTiY]o₃, et comportant des cations de substitution capables d'induire la formation de lacunes en oxygène, caractérisé en ce qu'il comprend les étapes suivantes :
- coprécipitation des différents cations composant la pérovskite de manière à créer des lacunes d'oxygène,
- mélange du précipité formé et d'un fluorure métallique ou non métallique,
- traitement thermique permettant l'insertion d'ions fluorures dans les lacunes d'oxygène, pour obtenir des propriétés piézoélectriques de la pérovskite jusqu'à environ 300°C

2. Procédé selon la revendication 1 pour la fabrication d'une pérovskite ferroélectrique de type titanozirconate de plomb, caractérisé en ce qu'il comprend les étapes suivantes :
- dissolution en solution aqueuse d'acide oxalique, de butylate de titane, de butylate de zirconium, de chlorure de fer et d'acétate de manganèse,
- addition d'un sel de plomb et de baryum à la solution précédente,
- agitation du mélange et ajustement à un pH proche de 9,
- mélange du précipité séché avec du fluorure de plomb,
- traitement thermique du mélange.

3. Procédé de fabrication de céramique du type pérovskite ferroélectrique fluorée, caractérisé en ce qu'il comprend les étapes suivantes :
- agglomération d'une poudre de pérovskite ferroélectrique fluorée fabriquée selon le procédé de l'une des revendications 1 à 2, avec un liant,
- moulage sous pression de l'agglomérat séché,
- déliantage par traitement thermique,
- frittage,
- usinage du produit obtenu,
- polarisation sous champ électrique de l'ordre de 3 à 5kV/mm.

## Claims

1. A method of manufacturing ferroelectric perovskite for preparing LZT ceramic of formula [Pbx][ZrTiY]O₃, and including substitution cations capable of inducing the formation of oxygen vacancies, said method being characterized in that it comprises the following steps:
co-precipitating the various cations making up the perovskite, so as to create oxygen vacancies;
mixing the resulting precipitate with a metallic fluoride or a non-metallic fluoride; and
applying heat treatment enabling fluoride ions to be inserted into the oxygen vacancies so that the perovskite has piezoelectric properties up to about 300°C.

2. A method according to claim 1 for manufacturing a ferroelectric perovskite of the lead zirconate titanate (LZT) type, said method being characterized in that it comprises the following steps:
dissolving the following in an aqueous solution: oxalic acid, titanium butylate, zirconium butylate, iron chloride, and manganese acetate;
adding a salt of lead and of barium to the resulting solution;
agitating the mixture and adjusting it to a pH in the vicinity of 9;
mixing the dried precipitate with lead fluoride; and
subjecting the mixture to heat treatment.

3. A method of manufacturing a ceramic of the fluorinated ferroelectric perovskite type, said method being characterized in that it comprises the following steps:
agglomerating a fluorinated ferroelectric perovskite powder with a binder and using the method according to claim 1 or 2;
molding the dried agglomerate under pressure;
unbinding by applying heat treatment;
sintering;
machining of the resulting product; and
polarizing under an electric field approximately in the range 3 kV/mm to 5 kV/mm.

## Patentansprüche

1. Verfahren zum Herstellen von ferroelektrischen Perovskiten zur Zubereitung von PZT-Keramiken entsprechend der Formel [Pbx].[ZrTiY] O₃, welche Substitutionskatione beinhalten und die Fähigkeit haben, das Bilden von Sauerstofflöchern einzuleiten, dadurch gekennzeichnet, daß es folgende Etappen umfaßt:
- Mischfällung der verschiedenen Katione, aus welchen sich das Perovskit zusammensetzt, so daß Sauerstofflöcher gebildet werden,
- Mischung des gebildeten Niederschlags und eines metallischen oder nicht metallischen Fluorids,
- Wärmebehandlung zum Einfügen von Fluorionen in die Sauerstofflöcher zum Erzielen von piezoelektrischen Eigenschaften bis zu 300° C.

2. Verfahren gemäß Patentanspruch 1 zum Herstellen eines ferroelektrischen Perovskits vom Typ Bleititanozirkonat, dadurch gekennzeichnet, daß es folgende Etappen beinhaltet:
- Auflösung in einer wäßrigen Lösung aus Oxalsäure, Titanbutyl, Zirkoniumbutyl, Ferrochlorid und Manganazetat,
- Hinzufügen von Bleisalz und Barium zur vorstehend angegebenen Lösung,
- Schütteln der Mischung und Justieren bei einem pH von annähernd 9,
- Mischen des getrockneten Niederschlags mit Fluorblei,
- Wärmebehandlung der Mischung.

3. Verfahren zum Herstellen von Keramiken vom Typ fluoriertes ferroelektrisches Pervoskit, dadurch gekennzeichnet, daß es die folgenden Etappen beinhaltet:
- Agglomerieren eines gemäß einem der Patentansprüche 1 bis 2 hergestellten fluorierten ferroelektrischen Perovskitpulvers mit einem Bindemittel,
- Druckguß des getrockneten Agglomerates,
- Entfernen des Bindemittels durch Wärmebehandlung,
- Sintern,
- Bearbeiten des gewonnenen Produktes,
- Polarisierung bei einem elektrischen Feld von ca. 3 bis 5 kV/mm.
